# EUROPEAN PATENT SPECIFICATION

(11) **EP 2 725 881 B1**
(45) Date of publication and mention of the grant of the patent: **24.06.2015**
(21) Application number: 13190371.8
(22) Date of filing: 25.10.2013
(51) Int. Cl.: H05K 1/02, H01L 23/552, H01L 23/498, H05K 1/18, G02F 1/1345

(54) **Chip on film and display device including the same**
Chip auf Folie und Anzeigevorrichtung damit
Puce sur film et dispositif d'affichage comprenant celle-ci

(30) Priority: 25.10.2012 KR 20120119149
(43) Date of publication of application: 30.04.2014
(73) Proprietor: Samsung Display Co., Ltd., Gyeonggi-Do (KR)
(72) Inventor: Lee, Hee-Kwon, Yongin-City Gyeonggi-Do (KR)
(74) Representative: Mounteney, Simon James

(56) References cited:
- US-A- 5 917 149
- US-A1- 2007 013 056
- US-A1- 2007 134 473
- US-A1- 2010 290 192

## Description

### BACKGROUND

### Field

The described technology relates generally to a chip on film and a display device including the same.

### Description of the Related Art

A display device includes a liquid crystal display (LCD), an organic light emitting diode (OLED) display, and the like, and particularly the OLED display includes a display substrate providing a pixel region and a non-pixel region, and a sealing substrate that is disposed to face the display substrate for encapsulation and attached to the substrate by a sealant such as epoxy. A plurality of light emitting elements connected in a matrix manner between a scan line and a data line to constitute a pixel is formed in the pixel region of the display substrate, and a scan driver and a data driver extending from the scan line and the data line of the pixel region and processing a signal provided from the outside through a pad to provide the processed signal to the scan line and the data line are formed in the non-pixel region. The scan driver and the data driver include a driving circuit processing the signal provided from the outside to generate a scan signal and a data signal, and are formed in the course of manufacturing the light emitting element or manufactured as a separate integrated circuit chip form to be mounted on the display substrate.

In the case where the scan driver and the data driver are manufactured in an integrated circuit chip form to be mounted on the display substrate, a drive IC may be mounted on a chip on film (COF) to be connected to the pad of the display substrate. A wire layer formed on the COF includes a RGB interface wire and the like, the aforementioned wire layer does not cause electromagnetic hindrances such as electromagnetic interference (EMI), but a wire layer of the COF applied to a flexible display device having high resolution includes wires for transferring high-speed data, for example, mobile industry processor interface (MIPI) wires, source output wires, and the like, causing electromagnetic hindrances such as electromagnetic interference (EMI).

Further, since the wire layer of the COF applied to the flexible display device of the thin film is formed of a single layer in order to form a thin chip on film, it is difficult to adjust an impedance matching level between the display substrate and the chip on film, and thus, it is difficult to remove noise by electromagnetic interference (EMI).

Further, in the case where an electromagnetic interference prevention tape adheres to the chip on film in order to block the electromagnetic wave, the thickness of the flexible display device is increased.

US 2010/0290192 relates to a COF having a heat dissipating material on the back surface of an insulating film. US 2007/0013056 relates to a COF having a ground layer. US 2007/0134473 relates to a flexible circuit film and display panel assembly.

The above information disclosed in this Background section is only for enhancement of understanding of the background of the described technology and therefore it may contain information that does not form the prior art that is already known in this country to a person of ordinary skill in the art.

### SUMMARY

The described technology has been made in an effort to provide a chip on film of a thin film, which can block an electromagnetic interference, and a display device including the same.

In a first aspect, the present invention provides a chip on film as recited in claim 1.

The mesh portion may be formed on a bending portion of the driving film.

The mesh portion may be a portion where a mesh pattern is formed on the electromagnetic wave blocking layer.

The electromagnetic wave blocking layer may be a metal-plated layer.

The chip on film may further include: an insulation layer covering the electromagnetic wave blocking layer.

The chip on film may further include: a cover layer covering the wire layer.

In a further aspect, the present invention provides a display device as recited in claim 7.

The display substrate may be a flexible substrate.

The driving chip may be positioned under the display substrate.

The mesh portion may be formed at a position corresponding to a bending portion of the driving film.

The electromagnetic wave blocking layer may be a metal-plated layer.

The mesh portion may be a portion where a mesh pattern is formed on the metal-plated layer.

The display device may further include: an insulation layer covering the electromagnetic wave blocking layer.

The display device may further include: a cover layer covering the wire layer.

The part of said electromagnetic wave blocking layer configured to block electromagnetic waves may cover an entire surface under the driving film, or it may cover a position corresponding to the driving chip under the driving film.

In a chip on film according to the embodiments, it is possible to minimize electromagnetic interference (EMI) in a display device to which the chip on film is connected by forming an electromagnetic wave blocking layer under a driving film by a metal-plated layer to block an electromagnetic wave occurring in a wire layer formed on the driving film, particularly a high-speed data transferring wire.

Further, it is possible to alleviate tension of a bending portion and improve electromagnetic susceptibility (EMS) by forming a mesh portion on the electromagnetic wave blocking layer at a position corresponding to the bending portion of the driving film.

### BRIEF DESCRIPTION OF THE DRAWINGS

FIG. 1 is a side view of a chip on film according to an example useful for understanding the present invention;
FIG. 2 is a base view of the chip on film of figure 1;
FIG. 3 is a side view of a state where a bending portion of the chip on film of figure 1 is bent;
FIG. 4 is a base view of a chip on film according to an embodiment of the present invention;
FIG. 5 is a side view of a state where a bending portion of the chip on film according to the embodiment is bent; and
FIG. 6 is a side view of a display device including the chip on film of figure 1.

### DETAILED DESCRIPTION

The present invention will be described more fully hereinafter with reference to the accompanying drawings, in which embodiments of the invention and examples useful for understanding the present invention are shown. As those skilled in the art would realize, the described embodiments may be modified in various different ways, all without departing from the scope of the present invention as defined by the appended claims.

The drawings and description are to be regarded as illustrative in nature and not restrictive. Like reference numerals designate like elements throughout the specification. The size and thickness of each configuration shown in the drawings are arbitrarily shown for understanding and ease of description, but the present invention is not limited thereto.

Throughout the specification, it will be understood that when an element such as a layer, film, region, or substrate is referred to as being "on" another element, it can be directly on the other element or intervening elements may also be present.

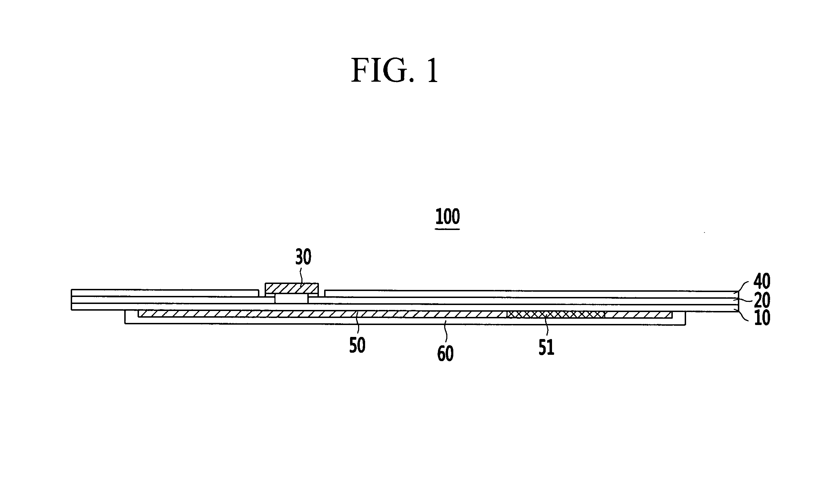

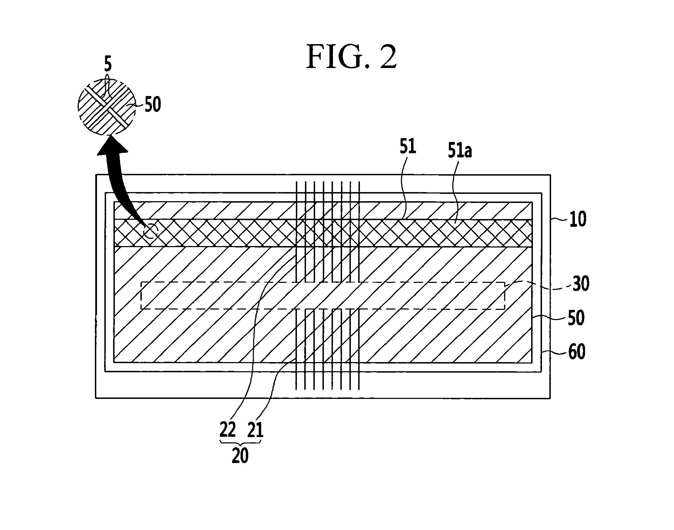

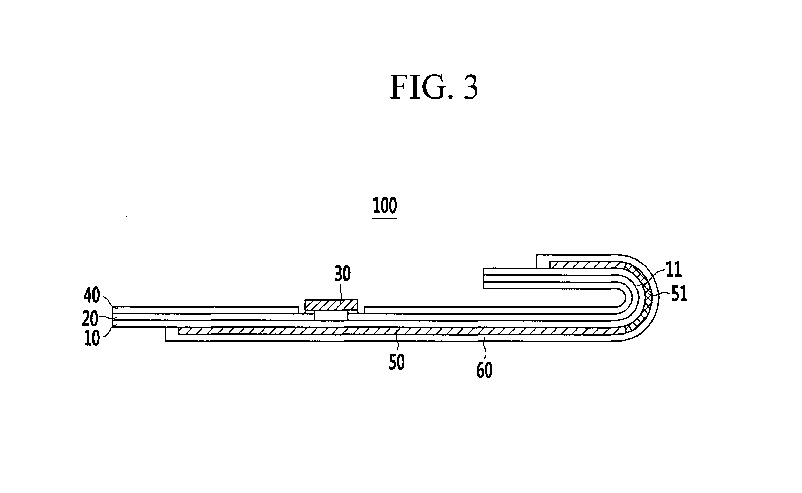

FIG. 1 is a side view of a chip on film according to an example useful for understanding the present invention, FIG. 2 is a base view of the chip on film of FIG. 1, and FIG. 3 is a side view of a state where a bending portion of the chip on film of FIG 1 is bent.

As shown in FIG. 1, a chip on film 100 according to an example useful for understanding the present invention includes a driving film 10, a wire layer 20 formed on the driving film 10, a driving chip 30 connected to the wire layer 20, a cover layer 40 covering the wire layer 20, an electromagnetic wave blocking layer 50 formed under the driving film 10, and an insulation layer 60 covering the electromagnetic wave blocking layer 50. In other words, the wire layer 20 is formed on a first surface of the driving film 10 while the electromagnetic wave blocking layer 50 is formed on a second surface of the driving film 10.

The driving film 10 may be a flexible film including polyimide and the like.

The wire layer 20 includes a plurality of signal transferring lines 21 and 22 transferring a driving signal to the driving chip 30 that acts as an interface between a flexible printed circuit (FPC) and a display substrate. The plurality of signal transferring lines includes an input signal transferring line 21 inputting a driving signal to the driving chip 30 and an output signal transferring line 22 outputting the driving signal from the driving chip 30.

The input signal transferring line 21 includes a high-speed data transferring wire, that affects electromagnetic interference (EMI), and the output signal transferring line 22 includes a source output wire, that affects electromagnetic susceptibility (EMS).

The electromagnetic wave blocking layer 50 blocks discharging of an electromagnetic wave occurring from the wire layer 20 to the outside, and the electromagnetic wave blocking layer 50 covers an entire surface under the driving film 10. The electromagnetic wave blocking layer 50 may be formed of a metal-plated layer to form a thin film, and the metal-plated layer may include electromagnetic wave blocking metal such as a copper-plated layer and may be formed of the same metal as the wire layer 20.

Accordingly, the electromagnetic wave blocking layer 50 may block the electromagnetic wave occurring in the wire layer 20 formed on the driving film 10, and particularly in the high-speed data transferring wire 21 through impedance matching to minimize the electromagnetic interference (EMI) occurring in the display device to which the chip on film 100 is connected.

As shown in FIGS. 2 and 3, the flexible driving film 10 (or the chip on film 100) has a bendable bending portion 11, and a mesh portion 51 is formed on the electromagnetic wave blocking layer 50 at a position corresponding to the bending portion 11. The mesh portion 51 is a portion where a mesh pattern 51a is formed on the electromagnetic wave blocking layer 50, and the mesh pattern 51a is formed by removing two diagonal layers 5 crossing each other from the electromagnetic wave blocking layer 50.

As described above, it is possible to improve the electromagnetic susceptibility (EMS) and alleviate tension of the bending portion 11 by forming the electromagnetic wave blocking layer 50 at a position corresponding to the bending portion 11 of the driving film 10 and forming the mesh portion 51 on the electromagnetic wave blocking layer 50 at the position corresponding to the bending portion 11 of the driving film 10.

Meanwhile, in the example of figures 1 to 3, the entire electromagnetic wave blocking layer 50 covers the entire surface under the driving film 10. However, in an embodiment of the present invention only a part of the electromagnetic wave blocking layer is configured to block electromagnetic waves, and this part of the layer covers only the position corresponding to the driving chip 30 under the driving film.

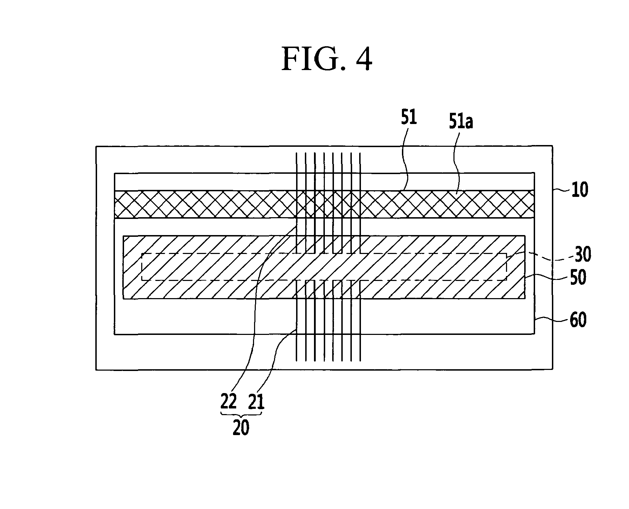

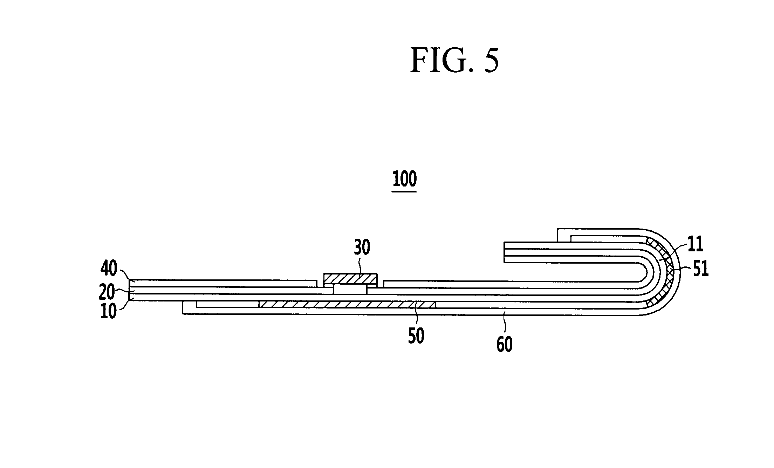

Hereinafter, the embodiment will be described in detail with reference to FIGS. 4 and 5.

FIG. 4 is a base view of a chip on film according to the embodiment.

The embodiment illustrated in FIGS. 4 and 5 is substantially the same as the example illustrated in FIGS. 1 to 3, with the exception of the configuration of the electromagnetic wave blocking layer, and a repeated description will be omitted.

As shown in FIGS. 4 and 5, the chip on film according to the embodiment includes a driving film 10, a wire layer 20 formed on the driving film 10, a driving chip 30 connected to the wire layer 20, a cover layer 40 covering the wire layer 20, an electromagnetic wave blocking layer 50 with a part which blocks electromagnetic waves formed under the driving film 10, and an insulation layer 60 covering the electromagnetic wave blocking layer 50.

The part of the electromagnetic wave blocking layer which blocks electromagnetic waves 50 covers the position corresponding to the driving chip 30 under the driving film 10, and may further cover the high-speed data transferring wire 21. The mesh portion 51 having the mesh pattern 51a may be formed at a position corresponding to the bending portion 11 of the driving film 10, while being spaced apart from the part of the electromagnetic wave blocking layer 50 that blocks electromagnetic waves between the driving film 10 and the insulation layer 60.

Accordingly, the electromagnetic wave blocking layer 50 may block the electromagnetic wave occurring in the high-speed data transferring wire 21 through impedance matching to minimize the electromagnetic interference (EMI) occurring in the display device to which the chip on film 100 is connected.

Meanwhile, hereinafter, the display device including the chip on film according to an example useful for understanding the present invention will be described in detail.

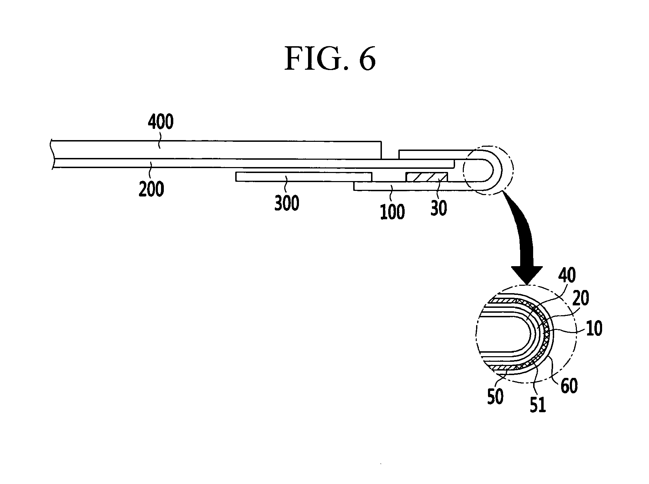

FIG. 6 is a side view of a display device including the chip on film.

As shown in FIG. 6, the display device including the chip on film includes the display substrate 200, the chip on film 100 connected to a periphery portion of the display substrate 200, and a flexible printed circuit (FPC) 300 connected to the chip on film 100.

The display substrate 200 may be a flexible substrate, and a sealing substrate 400 that is disposed to face the display substrate 200 for sealing and attached to the substrate by a sealant such as epoxy is formed on the display substrate 200.

The FPC 300 is connected through an anisotropic conductive film (ACF) to the chip on film 100. Accordingly, if a control signal and a data signal are provided from the outside through the FPC 300 to the driving chip 30 of the chip on film 100, the driving chip 30 generates a scan signal and a data signal, and the driving chip 30 transfers the generated signals through the scan line and the data line to the light emitting element of the display substrate 200.

The chip on film 100 includes the driving film 10, the wire layer 20 formed on the driving film 10, the driving chip 30 connected to the wire layer 20, the cover layer 40 covering the wire layer 20, the electromagnetic wave blocking layer 50 formed under the driving film 10, and the insulation layer 60 covering the electromagnetic wave blocking layer 50.

The electromagnetic wave blocking layer 50 blocks discharging of an electromagnetic wave occurring from the wire layer 20 to the outside, and the electromagnetic wave blocking layer 50 covers an entire surface under the driving film 10. The electromagnetic wave blocking layer 50 may be formed by the metal-plated layer to form a thin film, and the metal-plated layer may include electromagnetic wave blocking metal such as the copper-plated layer.

Accordingly, the electromagnetic wave blocking layer 50 may block the electromagnetic wave occurring in the wire layer 20 formed on the driving film 10, and particularly in the high-speed data transferring wire through impedance matching to minimize the electromagnetic interference (EMI) occurring in the display device to which the chip on film is connected.

Further, the flexible driving film 10 has the bendable bending portion 11, and the mesh portion 51 is formed between the driving film 10 and the insulation layer 60 at a position corresponding to the bending portion 11. The chip on film is bent at the bending portion 11 to be positioned under the display substrate 200.

As described above, it is possible to improve the electromagnetic susceptibility (EMS) and alleviate tension of the bending portion 11 by forming the electromagnetic wave blocking layer 50 at a position corresponding to the bending portion 11 of the driving film 10 and forming the mesh portion 51 on the electromagnetic wave blocking layer 50 at the position corresponding to the bending portion 11 of the driving film 10, thus maximizing a bending angle of the bending portion 11 to minimize the thickness of the bent chip on film. Therefore, the thickness of the flexible display device may be reduced.

While this disclosure has been described in connection with what is presently considered to be practical embodiments, it is to be understood that the invention is not limited to the disclosed embodiments, but, on the contrary, is intended to cover various modifications within the scope of the present invention as defined by the appended claims.

## Claims

1. A chip on film (100) comprising:
a driving film (10),
a wire layer (20) formed on a first surface of the driving film (10),
a driving chip (30) connected to the wire layer (20),
an electromagnetic wave blocking layer (50) formed on a second surface of the driving film (10) wherein at least a part of said electromagnetic wave blocking layer (50) is configured to block electromagnetic waves, and
a mesh portion (51) formed on the second surface of the driving film (10),
**characterised in that** said part of the electromagnetic wave blocking layer (50) configured to block electromagnetic waves covers a position corresponding to the driving chip (30) under the driving film (10) and said mesh portion (51) is spaced apart from said part of the electromagnetic wave blocking layer (50) configured to block electromagnetic waves.

2. The chip on film of claim 1, wherein the mesh portion (51) is formed on a bending portion (11) of the driving film (10).

3. The chip on film according to any preceding claim, wherein the mesh portion (51) is a portion where a mesh pattern (51a) is formed on the electromagnetic wave blocking layer (50).

4. The chip on film according to any preceding claim, wherein the at least a part of said electromagnetic wave blocking layer (50) configured to block electromagnetic waves is metal-plated.

5. The chip on film according to any preceding claim, further comprising an insulation layer (60) covering the electromagnetic wave blocking layer (50).

6. The chip on film according to any preceding claim, further comprising a cover layer (40) covering the wire layer (20).

7. A display device comprising:
a display substrate (200),
a chip on film (100) connected to a periphery portion of the display substrate (200), and
a flexible printed circuit (FPC) (300) connected to the chip on film (100), wherein the chip on film is a chip on film (100) as recited in any preceding claim.

8. The display device of claim 7, wherein the display substrate (200) is a flexible substrate.

9. The display device of claim 7, wherein the driving chip (30) is positioned under the display substrate (200).

## Patentansprüche

1. Chip auf Folie (100), umfassend:
eine Treiberfolie (10),
eine auf einer ersten Oberfläche der Treiberfolie (10) ausgebildete Drahtschicht (20),
einen mit der Drahtschicht (20) verbundenen Treiberchip (30),
eine Schicht (50) zum Blockieren elektromagnetischer Wellen, ausgebildet auf einer zweiten Oberfläche der Treiberfolie (10), wobei zumindest ein Teil der Schicht (50) zum Blockieren elektromagnetischer Wellen dazu geeignet ist, elektromagnetische Wellen zu blockieren, und
einen auf der zweiten Oberfläche der Treiberfolie (10) ausgebildeten Maschenabschnitt (51),
**dadurch gekennzeichnet, dass** der Teil der Schicht (50) zum Blockieren elektromagnetischer Wellen, der dazu geeignet ist, elektromagnetische Wellen zu blockieren, unter der Treiberfolie (10) eine Position bedeckt, die dem Treiberchip (30) entspricht, und der Maschenabschnitt (51) zu diesem Teil der Schicht (50) zum Blockieren elektromagnetischer Wellen, der dazu geeignet ist, elektromagnetische Wellen zu blockieren, beabstandet ist.

2. Chip auf Folie nach Anspruch 1, wobei der Maschenabschnitt (51) an einem gekrümmten Abschnitt (11) der Treiberfolie (10) ausgebildet ist.

3. Chip auf Folie nach einem der vorangehenden Ansprüche, wobei der Maschenabschnitt (51) ein Abschnitt ist, bei dem auf der Schicht (50) zum Blockieren elektromagnetischer Wellen ein Maschenmuster (51a) ausgebildet ist.

4. Chip auf Folie nach einem der vorangehenden Ansprüche, wobei der zumindest eine Teil der Schicht (50) zum Blockieren elektromagnetischer Wellen, der dazu geeignet ist, elektromagnetische Wellen zu blockieren, mit einem Metallüberzug versehen ist.

5. Chip auf Folie nach einem der vorangehenden Ansprüche, weiterhin umfassend eine die Schicht (50) zum Blockieren elektromagnetischer Wellen bedeckende Isolierschicht (60).

6. Chip auf Folie nach einem der vorangehenden Ansprüche, weiterhin umfassend eine die Drahtschicht (20) bedeckende Deckschicht (40).

7. Anzeigevorrichtung, umfassend:
ein Anzeigesubstrat (200),
einen Chip auf Folie (100), verbunden mit einem Randabschnitt des Anzeigesubstrats (200), und
eine flexible Leiterplatte (FPC) (300), verbunden mit dem Chip auf Folie (100), wobei der Chip auf Folie ein Chip auf Folie (100) nach einem der vorangehenden Ansprüche ist.

8. Anzeigevorrichtung nach Anspruch 7, wobei das Anzeigesubstrat (200) ein flexibles Substrat ist.

9. Anzeigevorrichtung nach Anspruch 7, wobei der Treiberchip (30) unter dem Anzeigesubstrat (200) positioniert ist.

## Revendications

1. Puce sur film (100) comprenant :
un film d'attaque (10),
une couche de câblage (20) formée sur une première surface du film d'attaque (10),
une puce d'attaque (30) raccordée à la couche de câblage (20),
une couche de blocage d'ondes électromagnétiques (50) formée sur une seconde surface du film d'attaque (10), au moins une partie de ladite couche de blocage d'ondes électromagnétiques (50) étant configurée pour bloquer des ondes électromagnétiques, et
une partie à mailles (51) formée sur la seconde surface du film d'attaque (10),
**caractérisé en ce que** ladite partie de la couche de blocage d'ondes électromagnétiques (50) configurée pour bloquer des ondes électromagnétiques recouvre une position qui correspond à la puce d'attaque (30) sous le film d'attaque (10) et ladite partie à mailles (51) est espacée par rapport à ladite partie de la couche de blocage d'ondes électromagnétiques (50) configurée pour bloquer des ondes électromagnétiques.

2. Puce sur film selon la revendication 1, dans laquelle la partie à mailles (51) est formée sur une partie cintrée (11) du film d'attaque (10).

3. Puce sur film selon l'une quelconque des revendications précédentes, dans laquelle la partie à mailles (51) est une partie où un motif à mailles (51a) est formé sur la couche de blocage d'ondes électromagnétiques (50).

4. Puce sur film selon l'une quelconque des revendications précédentes, dans laquelle la au moins une partie de ladite couche de blocage d'ondes électromagnétiques (50) configurée pour bloquer des ondes électromagnétiques est à placage métallique.

5. Puce sur film selon l'une quelconque des revendications précédentes, comprenant en outre une couche isolante (60) recouvrant la couche de blocage d'ondes électromagnétiques (50).

6. Puce sur film selon l'une quelconque des revendications précédentes, comprenant en outre une couche de couverture (40) recouvrant la couche de câblage (20).

7. Dispositif d'affichage comprenant :
un substrat d'affichage (200),
une puce sur film (100) raccordée à une partie périphérie du substrat d'affichage (200), et
un circuit imprimé flexible (FPC) (300) raccordé à la puce sur film (100), la puce sur film étant une puce sur film (100) selon l'une quelconque des revendications précédentes.

8. Dispositif d'affichage selon la revendication 7, dans lequel le substrat d'affichage (200) est un substrat flexible.

9. Dispositif d'affichage selon la revendication 7, dans lequel la puce d'attaque (30) est positionnée sous le substrat d'affichage (200).
